# EUROPEAN PATENT APPLICATION

(11) **EP 4 203 496 A1**
(43) Date of publication of application: **28.06.2023**
(21) Application number: 22186360.8
(22) Date of filing: 21.07.2022
(51) Int. Cl.: H04R 1/10

(54) **USB CRADLE WITH MAGNETIC DOCKING**

(30) Priority: 21.12.2021 CN 202111571133
(71) Applicant: Plantronics, Inc., Santa Cruz, California 95060 (US)
(72) Inventor: WU, Liying, Santa Cruz, 95060 (US)
(74) Representative: Haseltine Lake Kempner LLP

(57) **Abstract**

A universal serial bus (USB) cradle includes a USB connector configured to engage the USB cradle with an external device. The USB further includes a cradle base integrated with the USB connector. The cradle base includes a cavity configured to accept an audio device in a docked configuration, and a magnetic connector configured to hold the audio device in a given position and orientation when the audio device is docked with the USB cradle.

## Description

### FIELD

The present disclosure relates generally to universal serial bus (USB) cradles and charging for USB devices and, more particularly, to a USB cradle with magnetic docking.

### BACKGROUND

Headphones and headsets may be used by individual users to provide audio input and output to devices such as computers or mobile phones, speakerphones may be used to further provide audio input and output to a room or multiple users. Speakerphones may include a variety of directional microphones as well as echo cancelling circuitry so as to be able to receive clear audio input from different users positioned around the speakerphone in a manner that does not cause feedback.

### DESCRIPTION OF DRAWINGS

FIGURES 1A, 1B, 1C show views of a USB cradle with magnetic docking for a headset or headphone, according to embodiments of the present disclosure.
FIGURES 2A, 2B, 2C show a three-dimensional view of the USB cradle, and operation of the USB cradle to move between vertical and horizontal alignments, according to embodiments of the present disclosure.
FIGURE 3 shows an illustration of example headphone or headset to be used in conjunction with the USB cradle, according to embodiments of the present disclosure.
FIGURE 4 shows a system with an example base device such as a laptop or speakerphone or IP phone used in conjunction with the USB cradle, according to embodiments of the present disclosure.
FIGURE 5 shows a block diagram of the USB cradle, according to embodiments of the present disclosure.
FIGURE 6 illustrates an example method for operation of the USB cradle include seamless switching, according to embodiments of the present disclosure.

### DESCRIPTION

Inventors of embodiments of the present disclosure have discovered that some users may use headphones and headsets in conjunction with speakerphones or Internet Protocol (IP) phones to provide input and output to devices such as computers or mobile phones. Users may switch between use of a headphone or headset to use of a speakerphone or IP phone. Inventors of embodiments of the present disclosure have discovered that such use cases may be enhanced by seamless switching of audio between a headset or headphone and a speakerphone or IP phone. Some speakerphones could include a traditional audio port, such as a 3.5 mm stereo headphone jack, to facilitate such a handoff or switch between these devices. However, inventors of embodiments of the present disclosure have discovered embodiments that may facilitate handoffs or switches between these devices without use of a 3.5 mm stereo headphone jack. Moreover, inventors of embodiments of the present disclosure have discovered embodiments that may provide additional benefits for interfacing or using headphones or headsets in conjunction with speakerphones.

Embodiments of the present disclosure may include a USB cradle with magnetic docking for headsets or headphones. The USB cradle may be configured to receive a headset or headphone with ease for a user of the USB cradle, through the use of magnetic docking. Moreover, the USB cradle may include a USB Type-A or Type-C interface so that the USB cradle can be inserted into a speakerphone or other device and be supported by the speakerphone or other device. Using the combination of the headset or headphone and the speakerphone or other device is eased by the USB cradle, which may provide benefits such as easy access for the headset or headphone, quick mounting for charging the headset or headphone, quick mounting for seamless switching between use of the headphone or headphone and the speakerphone or other device, and reduced cabling therebetween. Moreover, in some embodiments, the USB cradle may also act as a Bluetooth dongle, providing further access between the headset or headphone and the speakerphone or other device. The USB cradle may facilitate automatic or seamless switching of data links between the headset or headphone and the speakerphone or other device, as the headset or headphone is removed from or inserted into the USB cradle. A data link between the headset or headphone and the speakerphone or other device that exists when the headset or headphone is inserted into the USB cradle may be maintained when the headset or headphone is removed from the USB cradle, albeit switched from a wired connection to a wireless connection. The wireless connection may be facilitated with equipment within the USB cradle. Similarly, a data link between the headset or headphone and the speakerphone or other device that exists when the headset or headphone in wireless communication with the speakerphone or other device may be maintained when the headset or headphone is inserted into the USB cradle, albeit switched from a wireless connection to a wired connection through the USB cradle.

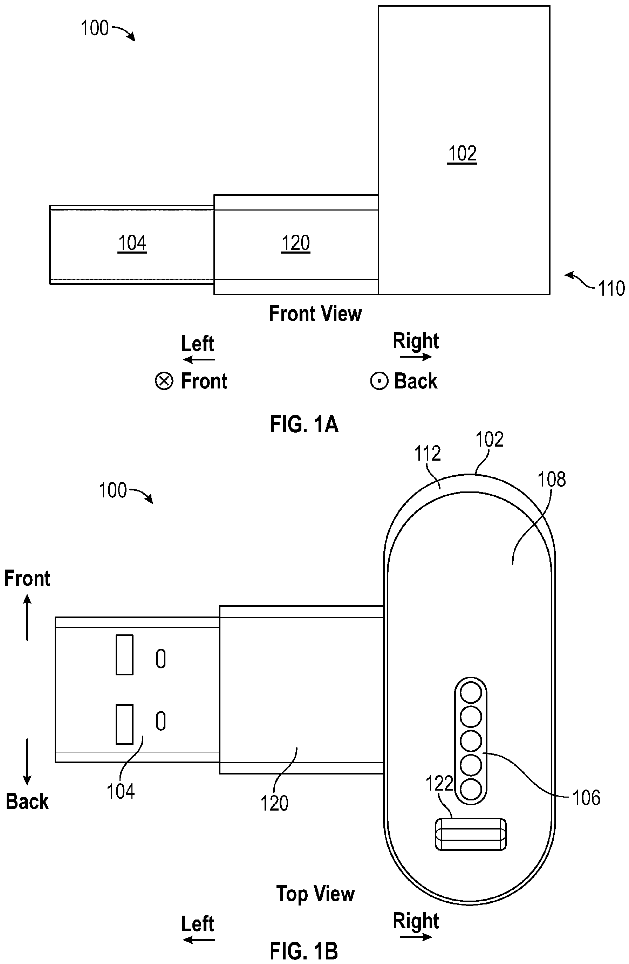

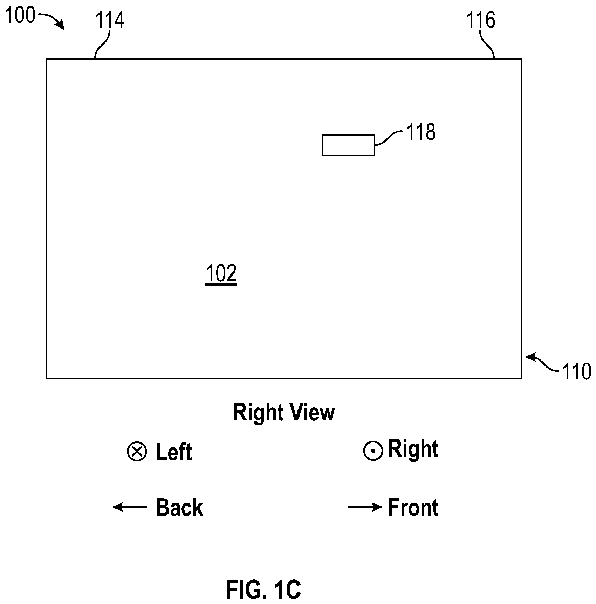

FIGURES 1A, 1B, 1C show views of an embodiment of a USB cradle 100 with magnetic docking for a headset or headphone, according to embodiments of the present disclosure.

FIGURE 1A may be referenced as a front view of USB cradle 100, FIGURE 1B may be referenced as a top view of USB cradle 100, and FIGURE 1C may be referenced as a right view of USB cradle 100. The designations of front, back, right, left, top, and bottom are made for reference only of orientation of USB cradle 100 in FIGURES 1A, 1B, 1C, and are not themselves limiting.

USB cradle 100 may be configured to receive any suitable audio device (not shown), such as a headset, headphone, or earbud. USB cradle 100 may be configured to hold such an audio device. USB cradle 100 may be configured to charge such an audio device. In some embodiments, USB cradle 100 may be configured to operate as a Bluetooth dongle for communication with such an audio device. USB cradle 100 may be configured to be plugged into any suitable USB element, device, or host, such as a speakerphone, IP phone, or laptop through a USB connection.

USB cradle 100 may include a cradle base 102 and a USB connector 104. Cradle base 102 may be of any suitable shape, size, or dimension. Cradle base 102 may be fabricated from any suitable substance, such as plastic. USB connector 104 may be, for example, a USB type A connector or a USB type C connector. USB connector 104 may be a male connector. In various embodiments, USB connector may be of any type suitable to support cradle base 102 when connected to a female USB connector. USB cradle 100 may include a cover 120 configured to surround and support USB connector 104. Cover 120 may protrude from USB cradle 100 in a same manner as USB connector 104.

Cradle base 102 may be configured to receive a portion of any suitable audio device during docking, as discussed above. Cradle base 102 may be shaped so as to accept partial insertion of the audio device into cradle base 102. \As shown in FIGURE 1B, cradle base 102 may include a partially open cavity 108 formed by a lip 112 on the top of cradle base 102. Cavity 108 may be configured to accept partial insertion of the audio device into cradle base 102. Cavity 108 may slope downwards from lip 112 to a bottom of a basin formed by cavity 108. Cavity 108 may receive the audio device portion while the audio device is docked. Contact may be made between the interior sides of cavity 108 onto the audio device on at least one side of the audio device while the audio device is docked. The contact between the interior sides of cavity 108 and the at least one side of the audio device may partially hold the audio device in place while the audio device is docked.

In other embodiments (not shown) cavity 108 might not be symmetrical. Moreover, in other embodiments (not shown), cavity 108 might not be fully in contact with the portion of the audio device while the audio device is docked. The dimensions of cavity 108 may define the portions of the audio device that may contact cavity 108 while the audio device is docked. For example, in the right view shown in FIGURE 1C, the front top end 116 of cradle base 102 and the rear top end 114 of cradle base 102 may be of equal height. However, in other example implementations (not shown), the front top end 116 may be at a full height as shown, while the rear top end 114 of cradle base 102 may be of a much lower height, closer to the base of cradle base 102. This may allow partial insertion of the audio device with movement of the audio device from the back of cradle base 102 towards the front of cradle base 102 resulting of insertion of a portion of the audio device into cavity 108, rather than solely a vertical downward insertion of the audio device into cavity 108. Any suitable formation of cavity 108 to allow insertion of a portion of the audio device into cradle base 102 may be used.

Cradle base 102 may be configured to hold the audio device in place through magnetic force. In one embodiment, the magnetic force may be provided by a magnetic connector 106. Any suitable magnetic connector 106 implementation may be used, such as a five-pin or two-pin magnetic connector. When a corresponding portion of the audio device, which may also include a magnetic connector, is inserted into cavity 108 in proximity to magnetic connector 106, the magnetic force between the two connectors may pull the audio device into position and into connection with magnetic connector 106. The connection may provide USB communication and an orientation force to hold the audio device within cradle base 102 and cavity 108. As discussed above, physical contact between walls of cavity 108 and sides of the audio device may provide some amount of support or orientation of the audio device while the audio device is docked. However, in some embodiments, the magnetic force between magnetic connector 106 and the connector of the audio device may provide substantially more (that is, at least half) of the force necessary to orient and support the audio device while the audio device is docked. Furthermore, cradle base 102 may include a protrusion 122 extending up from cavity 108. Protrusion 122 may extend up from cavity 108 at any suitable angle. Protrusion 122 may be configured to be inserted into or mate with a corresponding cavity of a headphone placed into cradle base 102.

Magnetic connector 106 may be positioned within cavity 108 at any suitable place therein. The specific position of magnetic connector 106 within cavity 108 may be made based upon the corresponding position of the connector of the audio device. Moreover, the specific position of magnetic connector 106 within cavity 108 may be selected so as to position and support the audio device in a desired orientation and position while the audio device is docked, such as upright and accessible to be picked up by a user.

As shown in FIGURE 1C, USB cradle 100 may include any suitable number and kind of additional ports 118. Such ports 118 may be used, for example, for additional USB connections for cables, other communications protocols such as 3.5 mm stereo plugs, lighting cable ports, charging ports, or any other suitable communication or power interface or protocol. These may allow, for example, USB cradle 100 to communicate with yet other USB elements, or to be powered or charged in a stand-alone manner without being plugged into other USB elements.

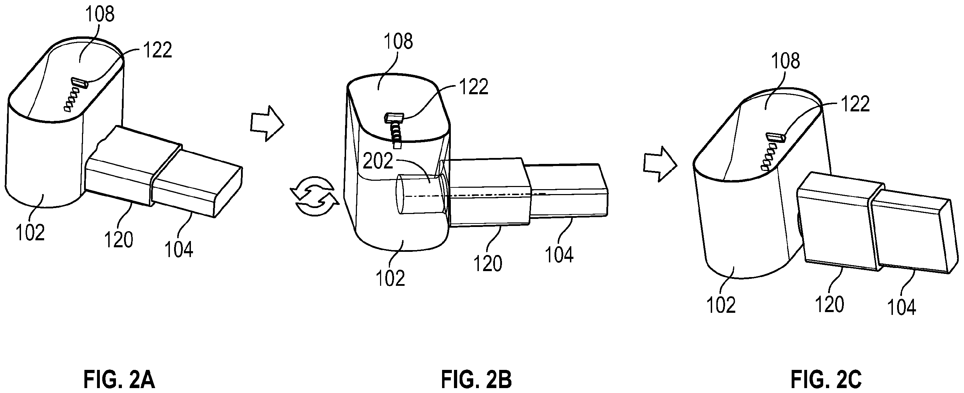

FIGURES 2A, 2B, and 2C show a three-dimensional view of USB cradle 100, and of operation of USB cradle 100 to move between vertical and horizontal alignments, according to embodiments of the present disclosure. As shown in FIGURES 1A, 1B, 1C, USB connector 104 may have a horizontal alignment, wherein USB cradle 100 is configured to mate with a corresponding horizontally aligned USB port in a host device such that USB connector 104 is horizontal and USB cradle 100 is upright to accept insertion of a headphone from above. USB cradle 100 may be configured to also be inserted into a vertically aligned USB port in a host device such that USB cradle 100 is still upright to accept insertion of a headphone from above. USB cradle 100 may include any suitable type of mechanism so that USB cradle 100 may pivot, twist, swing, swivel, or otherwise move between having its USB connector 104 aligned horizontally or vertically. For example, USB cradle 100 may include a hinge 124. Hinge 124 may be configured to allow a user to manipulate USB connector 104 from being aligned in a horizontal position to being aligned in a vertical position, and back.

In FIGURE 2A, USB connector 104 may be aligned in a horizontal position.

In FIGURE 2B, USB connector 104 may be rotated in a clockwise or counterclockwise manner along an axis protruding out from the end opening of USB connector 104.

In FIGURE 2C, USB connector 104 may be aligned in a vertical position after being rotated in FIGURE 2B.

Similarly, USB connector 104 may be rotated back to a horizontal position as shown in FIGURE 2A.

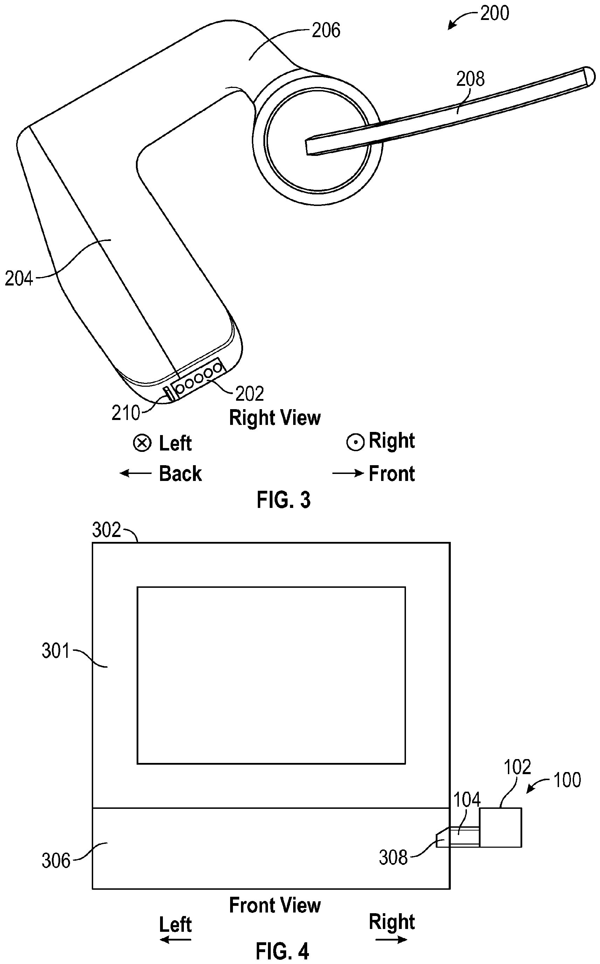

FIGURE 3 shows an illustration of example headphone 200 to be used in conjunction with the USB cradle, according to embodiments of the present disclosure. Headphone 200 may represent an example audio device to be used with USB cradle 100 of FIGURES 1A, 1B, 1C. Although a particular example is illustrated, the audio device may be implemented in any suitable manner. Shown in FIGURE 3 may be a right view of headphone 200. The example of headphone 200 may include a body 204 angled with an earpiece 206 to fit over a user's ear, as well as an external boom microphone 208.

In one embodiment, headphone 200 may include a magnetic connector 202 that is a counterpart to magnetic connector 106. Connectors 202, 106 may include complementary magnets or magnetic components of any suitable size, shape, make, or manufacture with polarities that attract connectors 202, 106 to each other and connect to each other in a given position. Magnetic connector 202 may be placed in any suitable part or location on headphone 200. Magnetic USB connector 202 may be on a portion of headphone 200 that is to be partially inserted into USB cradle 100, specifically within cavity 108. The position of magnetic connector 202 may be selected so as to orient and support headphone 200 in a desired position while docked in USB cradle 100.

The particular geometry and implementation of headphone 200 may be used to determine where to place connector 202, and thus also magnetic connector 106 within cavity 108. The weight of headphone 200 may be evenly, or substantially evenly, balanced between the front and back sides of headphone 200 along a vertical axis at magnetic connector 202. Thus, when headphone 200 is docked in USB cradle 100, there may be roughly even weight of headphone 200 tipping headphone 200 forwards or backwards. The placement of connectors 202, 106 may be made so that sufficient magnetic force is applied to overcome any moment, inertia, or imbalance of weight of headphone 200 that would otherwise cause headphone 200 to move to an undesired position or orientation while docked with USB cradle 100. Moreover, the contact between surfaces of cavity 108 with sides of headphone 200 may further assist in maintaining a position or orientation of headphone 200 while docked with USB cradle 100. In addition, a cavity 210 may be configured to accept protrusion 122 to further hold headphone 200 in a position or orientation while docked with USB cradle 100.

FIGURE 4 shows a system with an example base device 302 such as a laptop, IP phone, or speakerphone used in conjunction with USB cradle 100, according to embodiments of the present disclosure. Base device 302 may include a base 306 and any suitable number and kind of additional portions 304, such as a screen. Base device may include a USB connector 308 configured to accept USB connector 104 of USB cradle 100. When USB connector 104 of USB cradle 100 is inserted into USB connector 308 of base device 302, a USB connection may be made. In the example shown in FIGURE 4, USB connector 104 is shown but in practice might not be visible due to its insertion into USB connector 308. USB connector 308 may be a female USB Type A or USB Type C connector.

In one embodiment, USB cradle 100, when inserted into base device 302, may be physically supported by the insertion of USB connector 104 into USB connector 308. This may cause USB cradle 100 to be lifted off of any ground or surface on which USB cradle 100 would otherwise rest. In turn, when an audio device such as headphone 200 is docked in USB cradle 100, headphone 200 is also physically supported by the insertion of USB connector 104 into USB connector 308.

Returning to FIGURE 1A and FIGURE 1C, in contrast, when USB cradle 100 is not inserted into base device 302, USB cradle 100 may rest on a surface on bottom 110. As shown in FIGURE 1A and FIGURE 1C, bottom 110 may be wider than a top of USB cradle 100, or flared out. This may provide stability for USB cradle 100 to provide docking for an audio device such as headphone 200 when USB cradle 100 is not inserted into base device 302. Thus, USB cradle 100 may provide a desired position and orientation for an audio device such as headphone 200 when the audio device is docked in USB cradle 100, in situations wherein USB cradle 100 is inserted or not inserted into base device 302.

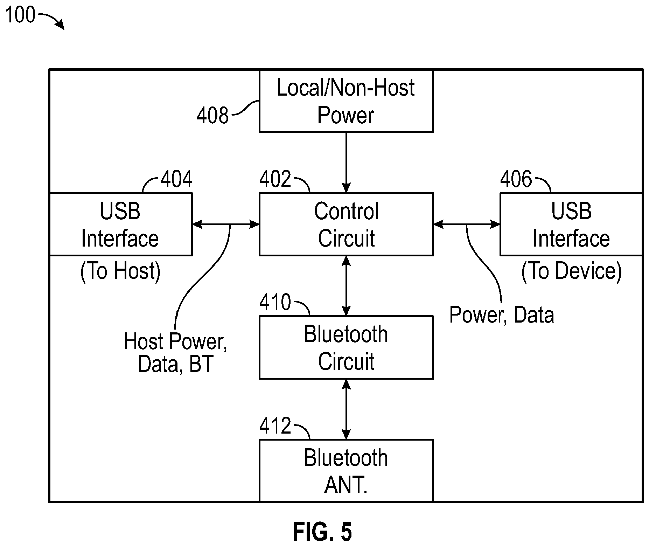

FIGURE 5 shows a block diagram of USB cradle 100, according to embodiments of the present disclosure. USB cradle 100 may include more or fewer components than shown. Moreover, the separate illustrated components of USB cradle 100 may be implemented together or separately as provided by a selected implementation thereof.

USB cradle 100 may include a control circuit 402. Control circuit 402 may be implemented by analog circuitry, digital circuitry, a field programmable gate array (FPGA), an application specific integrated circuit (ASIC), instructions for execution by a processor, or any suitable combination thereof. Control circuit 402 may be configured to monitor for connections between USB cradle 100 to other elements and facilitate the interoperations between them.

USB cradle 100 may include a local or non-host power source 408, such as a battery. Local or non-host power source 408 may be configured to be charged when USB cradle 100 is connected to a power source through, for example, port 118 or USB connector 104 to base device 302. When USB cradle 100 is disconnected from base device 302 or another power source through port 118, and headphone 200 is docked in USB cradle 100, control circuit 402 may be configured to cause local or non-host power source 408 to charge headphone 200.

USB cradle 100 may include any suitable number and kind of USB interfaces, such as USB interfaces 404, 406. Interfaces 404, 406 may be implemented by analog circuitry, digital circuitry, an FPGA, an ASIC, instructions for execution by a processor, or any suitable combination thereof. Interface 404 may be configured to connect to one USB element, such as base device 302. Interface 406 may be configured to connect to another USB element, such as headphone 200 or another audio device. In such an arrangement, base device 302 may be a USB host and headphone 200 may be a USB device. Control circuit 402 may be configured to provide any suitable power and data connections between the two USB elements according to any suitable USB protocol. Control circuit 402 may be configured to facilitate the charging of headphone 200 from base device 302, for example, while headphone 200 is docked in USB cradle 100. Control circuit 402 may be configured to act as a USB bridge, On-the-Go (OTG) link, or any other suitable USB element to facilitate data and power exchange between elements connected to interfaces 404, 406.

USB cradle 100 may include a Bluetooth circuit 410 and a Bluetooth antenna 412. Bluetooth circuit 410 may be implemented by analog circuitry, digital circuitry, an FPGA, an ASIC, instructions for execution by a processor, or any suitable combination thereof. Inclusion of Bluetooth circuit 410 and Bluetooth antenna 412 may allow USB cradle 100 to act as a Bluetooth dongle. USB cradle 100, when connected to base device 302 through USB interface 404, may provided communications to and from headphone 200 and base device 302 through Bluetooth when headphone 200 is not docked in USB cradle 100. The translation and bridging of communication from devices communicatively coupled through Bluetooth antenna 412 to other elements communicatively coupled through USB interface 404 may be performed by control circuit 402.

When USB cradle 100 is inserted into base device 302, control circuit 402 may be configured to determine whether headphone 200 is docked to USB cradle 100 through an active USB connection on USB interface 406. If headphone 200 is not docked, control circuit 402 may be configured to act as a communications link between base device 302 and headphone 200 through Bluetooth antenna 412 or any another suitable wireless protocol. If a docking of headphone 200 is detected, control circuit 402 may be configured to notify base device 302, which may switch audio I/O from headphone 200 to audio I/O directly from base device 302. Such audio I/O directly from base device 302 may be provided by, for example, speakerphone speakers and microphones of base device 302. If an undocking of headphone 200 is detected, control circuit 402 may be configured to notify base device 302. Base device 302 may immediately switch from providing audio I/O directly from base device 302 to headphone 200. Base device 302 may wait to switch such audio I/O until headphone 200 is undocked and has been powered on or otherwise activated by a user. Upon switching such audio I/O to headphone 200, wireless communication may be facilitated between headphone 200 and base device 302 through Bluetooth antenna 412 or through any other suitable wireless connection.

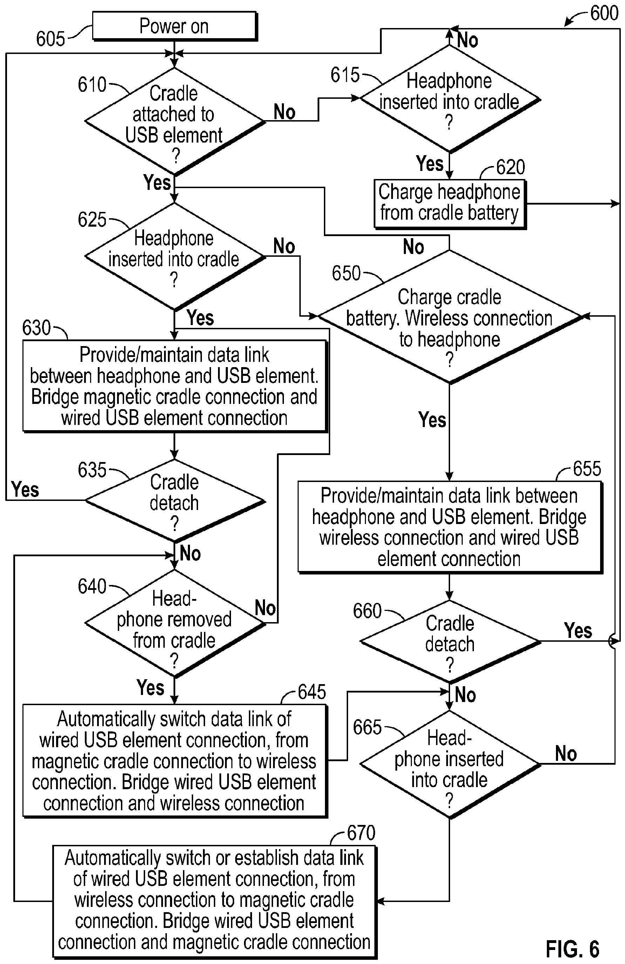

FIGURE 6 illustrates an example method 600 for operation of USB cradle 100 including seamless switching, according to embodiments of the present disclosure. Method 600 may be performed by any suitable apparatus, such as by USB cradle 100 as shown and described in FIGURES 1-5 and, more particularly, control circuit 402. Method 600 may include more or fewer steps than those down in FIGURE 6. Moreover, various steps of method 600 may be omitted, repeated, performed in parallel, performed recursively, or in any suitable order. Method 600 may begin at any suitable step, such as step 605.

At step 605, USB cradle 100 may be powered on.

At step 610, control circuit 402 may determine whether USB cradle 100 is connected to a USB element, such as a speakerphone, IP phone, or laptop, through a wired USB connection with the element. Such a determination may be a determination that USB cradle 100 is inserted into such a USB element. If so, method 600 may proceed to step 625. Otherwise, method 600 may proceed to step 615.

At step 615, control circuit 402 may determine whether a headphone, such as headphone 200, is inserted into USB cradle 100. If so, method 600 may proceed to step 620. Otherwise, method 600 may return to step 610.

At step 620, control circuit 402 may cause headphone 200 to be charged from local or non-host power source 408, such as a battery. Method 600 may return to step 610.

At step 625, control circuit 402 may determine whether headphone 200 is inserted into USB cradle 100. If so, method 600 may proceed to step 630. Otherwise, method 600 may proceed to step 650.

At step 630, control circuit 402 may establish or maintain an established data link between headphone 200 and the USB element. Control circuit 402 may be communicatively coupled to headphone 200 through a magnetic cradle connection such as through magnetic connector 106. Control circuit 402 may be communicatively coupled with the USB element through connector 104. Control circuit 402 may be configured to bridge these two connections and provide data communications between headphone 200 and the USB element. Control circuit 402 may cause headphone 200 to be charged by the USB element.

At step 635, control circuit 402 may determine whether USB cradle 100 has detached from the USB element. If so, method 600 may return to step 610. Otherwise, method 600 may proceed to step 640. Moreover, step 635 may be performed at any suitable part of method 600, although illustrated as between steps 630 and 640. For example, step 635 may be performed at any point after cradle attachment has been detected in step 610. In such scenarios, if USB cradle 100 has not been detached, method 600 may proceed to the step to which it was otherwise proceeding.

At step 640, control circuit 402 may determine whether headphone 200 has been removed from USB cradle 100. If so, method 600 may proceed to step 645. Otherwise, method 600 may return to 630.

At step 645, control circuit 402 may automatically switch a data link between headphone 200 and the USB element to be a wireless data link. Such switching may be automatic and seamless as perceived by a user. Control circuit 402 might no longer be communicatively coupled to headphone 200 through magnetic connector 106. The wireless data link may be established by wireless mechanisms on the USB element, or by wireless mechanisms in USB cradle 100, such as Bluetooth circuit 410 and Bluetooth antenna 412. If the wireless data link is accomplished by wireless mechanisms on the USB element, control circuit 402 may signal to the USB element that headphone 200 has been removed. Furthermore, control circuit 402 may signal to the USB element that the USB element is to establish or maintain the wireless connection with headphone 200. If the wireless data link is accomplished by wireless mechanisms in USB cradle 100, such as Bluetooth circuit 410 and Bluetooth antenna 412, control circuit 402 may establish or maintain the wireless connection with headphone 200. Method 600 may proceed to step 665.

At step 650, control circuit 402 may cause a local or non-host power source 408, such as a battery, to be charged. Control circuit 402 may determine whether a wireless connection exists with headphone 200. The wireless connection may be through, for example, Bluetooth circuit 410 and Bluetooth antenna 412. The wireless connection may be through, for example, components within the USB element. If there is a wireless connection, method 600 may proceed to step 655. Otherwise, method 600 may return to step 625.

At step 655, a data link with headphone 200 may be established or maintained. If the wireless connection is made through components within the USB element, the data link between headphone 200 and the USB element may be maintained by the USB element. If the wireless connection is made through components within USB cradle 100 (such as Bluetooth circuit 410 and Bluetooth antenna 412), then control circuit 402 may be communicatively coupled to headphone 200 through such components. Control circuit 402 may still be communicatively coupled with the USB element through connector 104. Control circuit 402 may be configured to bridge these two connections and provide data communications between headphone 200 and the USB element.

At step 660, control circuit 402 may determine whether USB cradle 100 has detached from the USB element. If so, method 600 may return to step 610. Otherwise, method 600 may proceed to step 665. As discussed above within the context of step 635, this may be performed at any suitable part of method 600, such as any point after cradle attachment has been detected in step 610.

At step 665, control circuit 402 may determine whether headphone 200 has been inserted into USB cradle 100. If so, method 600 may proceed to step 670. Otherwise, method 600 may return, for example, to step 650.

At step 670, control circuit 402 may automatically switch a data link between headphone 200 and the USB element to be a wired data link. Such switching may be automatic and seamless as perceived by a user. The previously existing wireless data link may be transferred to a wired connection. The previously existing wireless data link may have been established by wireless mechanisms on the USB element, or by wireless mechanisms in USB cradle 100, such as Bluetooth circuit 410 and Bluetooth antenna 412. If the previously existing wireless data link was accomplished by wireless mechanisms on the USB element, control circuit 402 may signal to the USB element that headphone 200 has been inserted. Furthermore, control circuit 402 may signal to the USB element that communications with headphone 200 will be provided through control circuit 402. If the wireless data link is accomplished by wireless mechanisms in USB cradle 100, such as Bluetooth circuit 410 and Bluetooth antenna 412, control circuit 402 may establish or maintain a wired connection through, for example, connector 106, while maintaining the USB element connection with the USB element. Control circuit 402 may be configured to bridge these two connections and provide data communications between headphone 200 and the USB element. USB Method 600 may proceed to step 640.

Embodiments of the present disclosure may include a USB cradle. The USB cradle may include a USB connector configured to engage the USB cradle with an external device. The USB connector may be implemented according to any suitable USB protocol, such as USB Type A or USB Type C. The external device may be any suitable device configured to accept a USB element, such as a speakerphone, IP phone, or laptop through a USB connection. The external device may be a USB host or a USB hub. The USB cradle may be formed by any suitable material, such as plastic. The USB cradle may include any suitable number of segments or portions of any suitable geometry. The USB cradle may include a cradle base integrated with the USB connector. The cradle base may include a cavity configured to accept an audio device when the audio device is in a docked configuration with the USB cradle. The cradle base may further include a magnetic connector configured to hold the audio device in a given position and orientation when the audio device is docked with the USB cradle. The magnetic connector may be, for example, a 2-pin or 5-pin connector configured to communicate between the audio device and the USB cradle. The USB cradle may include any suitable circuitry to facilitate the communication between the audio device, the USB cradle, and USB elements to which the USB cradle is connected.

In combination with any of the above embodiments, the USB connector may be configured to support the USB cradle when the USB cradle is inserted into the external device.

In combination with any of the above embodiments, the USB connector may be configured to further support the audio device when the audio device is docked with the USB cradle.

In combination with any of the above embodiments, the USB cradle may further include a wireless antenna (such as a Bluetooth antenna) and a control circuit, wherein the control circuit is configured to cause the USB cradle to act as a wireless dongle (such as a Bluetooth dongle) for the audio device when the USB cradle is inserted into the external device.

In combination with any of the above embodiments, the USB cradle may further include a control circuit, wherein the control circuit is configured to detect a docking of the audio device into the cavity and, upon detection of the docking of the audio device, cause charging of the audio device. The control circuit may be implemented by analog circuitry, digital circuitry, an ASIC, an FPGA, instructions for execution by a processor, or any suitable combination thereof.

In combination with any of the above embodiments, the control circuit may be configured to cause charging of the audio device from the external device based on a determination that the USB cradle is inserted into the external device.

In combination with any of the above embodiments, the magnetic connector may be placed within the cavity at a location to cause the audio device to maintain the given position and orientation when the audio device is docked with the USB cradle.

In combination with any of the above embodiments, the magnetic connector may be placed within the cavity at the location to balance the audio device in the given position and orientation with a magnetic force sufficient to maintain the given position and orientation when the audio device is docked with the USB cradle.

In combination with any of the above embodiments, the cavity may be open on a top and at least partially on one side to allow both vertical and non-vertical insertion of the audio device into the USB cradle to dock with the USB cradle.

In combination with any of the above embodiments, the control circuit may be configured to determine at a first time that the audio device is not docked with the USB cradle. The control circuit may be configured to, based upon a determination that the audio device is not docked with the USB cradle, cause a wireless data link to be provided between the audio device and the external device. The control circuit may be configured to determine at a second time after the first time that the audio device is docked with the USB cradle and that the USB cradle is inserted into the external device. The control circuit may be configured to, based upon the determination that the audio device is docked with the USB cradle and that the USB cradle is inserted into the external device at the second time, cause the wireless data link to be switched to a wired data link between the audio device and the external device.

In combination with any of the above embodiments, the control circuit may be configured to determine at a third time that the audio device is docked with the USB cradle and that the USB cradle is inserted into the external device. The control circuit may be configured to, based upon a determination that the audio device is docked with the USB cradle, provide a wired data link between the audio device and the external device. The control circuit may be configured to determine at a fourth time after the third time that the audio device is not docked with the USB cradle. The control circuit may be configured to, based upon the determination that the audio device is not docked with the USB cradle at the second time, cause the wired data link to be switched to a wireless data link between the audio device and the external device.

Embodiments of the present disclosure may include a system. The system may include an audio device of any of the above embodiments and a USB cradle of any of the above embodiments.

The invention has been described in the preceding using various exemplary embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor, module, or other unit or device may fulfill the functions of several items recited in the claims.

The term "exemplary" used throughout the specification means "serving as an example, instance, or exemplification" and does not mean "preferred" or "having advantages" over other embodiments.

The mere fact that certain measures are recited in mutually different dependent claims or embodiments does not indicate that a combination of these measures cannot be used to advantage. Any reference signs in the claims should not be construed as limiting the scope.

Specific embodiments of the invention are here described in detail, above. In the preceding description of embodiments of the invention, the specific details are described in order to provide a thorough understanding of the invention. However, it will be apparent to one of ordinary skill in the art that the invention may be practiced without these specific details. In other instances, well-known features have not been described in detail to avoid unnecessarily complicating the instant description.

In the preceding explanation of the present invention according to the embodiments described, the terms "coupled (to/with)" and "connected (to/with)" are used to indicate a data or audio connection between at least two parts, components, or objects. Such a connection may be direct between the respective parts, components, or objects; or indirect, i.e., over intermediate parts, components, or objects. The connection may be a wired or wireless connection. It is noted that the above terms may also be used to indicate a physical or mechanical connection.

In the preceding description, ordinal numbers (e.g., first, second, third, etc.) may be used as an adjective for an element *(i.e.,* any noun in the application). The use of ordinal numbers is not to imply or create any particular ordering of the elements nor to limit any element to being only a single element unless expressly disclosed, such as by the use of the terms "before", "after", "single", and other such terminology. Rather, the use of ordinal numbers is to distinguish between like-named elements. For example, a first element is distinct from a second element, and the first element may encompass more than one element and succeed (or precede) the second element in an ordering of elements.

## Claims

1. A universal serial bus, USB, cradle ((100), comprising:
a USB connector (104) configured to engage the USB cradle with an external device (306); and
a cradle base (102) integrated with the USB connector, the cradle base including:
a cavity (108) configured to accept an audio device (200) in a docked configuration; and
a magnetic connector (106) configured to hold the audio device in a given position and orientation when the audio device is docked with the USB cradle.

2. The USB cradle of Claim 1, wherein the USB connector is configured to support the USB cradle when the USB cradle is inserted into the external device.

3. The USB cradle of Claim 2, wherein the USB connector is configured to further support the audio device when the audio device is docked with the USB cradle.

4. The USB cradle of Claim 1, further comprising a wireless antenna (412) and a control circuit (402), wherein the control circuit is configured to cause the USB cradle to act (655) as a wireless dongle for the audio device when the USB cradle is inserted into the external device.

5. The USB cradle of Claim 1, further comprising a control circuit (402), wherein the control circuit is configured to detect (625) a docking of the audio device into the cavity and, upon detection of the docking of the audio device, cause (630, 650) charging of the audio device.

6. The USB cradle of Claim 5, wherein the control circuit is configured to cause (630) charging of the audio device from one of:
the external device based on a determination that the USB cradle is inserted into the external device
a power source in the USB cradle based on a determination (610) that the USB cradle is not inserted into the external device.

7. The USB cradle of Claim 1, further comprising a control circuit (402) configured to either:
determine (625) at a first time that the audio device is not docked with the USB cradle;
based upon a determination that the audio device is not docked with the USB cradle, cause (655) a wireless data link to be provided between the audio device and the external device;
determine (665) at a second time after the first time that the audio device is docked with the USB cradle and that (610) the USB cradle is inserted into the external device;
based upon the determination that the audio device is docked with the USB cradle and that the USB cradle is inserted into the external device at the second time, cause (670) the wireless data link to be switched to a wired data link between the audio device and the external device;
or
determine (625) at a first time that the audio device is docked with the USB cradle and that (610) the USB cradle is inserted into the external device;
based upon a determination that the audio device is docked with the USB cradle, provide (630) a wired data link between the audio device and external device;
determine (640) at a second time after the first time that the audio device is not docked with the USB cradle;
based upon the determination that the audio device is not docked with the USB cradle at the second time, cause (670) the wired data link to be switched to a wireless data link between the audio device and the external device.

8. The USB cradle of Claim 1, wherein the magnetic connector is placed within the cavity at a location to cause the audio device to maintain the given position and orientation when the audio device is docked with the USB cradle

9. The USB cradle of Claim 8, wherein the magnetic connector is placed within the cavity at the location to balance the audio device in the given position and orientation with a magnetic force sufficient to maintain the given position and orientation when the audio device is docked with the USB cradle.

10. A method, comprising on a USB cradle, the USB cradle configured to engage with an external device (306) and configured to accept an audio device (200) in a docked configuration:
determining (625) at a first time that the audio device is not docked with the USB cradle;
based upon a determination that the audio device is not docked with the USB cradle, causing (655) a wireless data link to be provided between the audio device and the external device;
determining (665) at a second time after the first time that the audio device is docked with the USB cradle and that (610) the USB cradle is inserted into the external device;
based upon the determination that the audio device is docked with the USB cradle and that the USB cradle is inserted into the external device at the second time, causing (670) the wireless data link to be switched to a wired data link between the audio device and the external device;
or.
determining (625) at a first time that the audio device is docked with the USB cradle and that (610) the USB cradle is inserted into the external device;
based upon a determination that the audio device is docked with the USB cradle, providing (630) a wired data link between the audio device and the external device;
determining (640) at a second time after the first time that the audio device is not docked with the USB cradle;
based upon the determination that the audio device is not docked with the USB cradle at the second time, causing (670) the wired data link to be switched to a wireless data link between the audio device and the external device.

11. The method of Claim 10, wherein the USB cradle of Claim 1 further includes a wireless antenna (412), the method further comprising causing the USB cradle to act (655) as a wireless dongle for the audio device when the USB cradle is inserted into the external device.

12. The method of Claim 10, further comprising detecting (625) a docking of the audio device into the cavity and, upon detection of the docking of the audio device, causing (630, 650) charging of the audio device.

13. The method of Claim 12, further comprising one of:
causing (630) charging of the audio device from the external device based on a determination that the USB cradle is inserted into the external device
causing (620) charging of the audio device from a power source in the USB cradle based on a determination (610) that the USB cradle is not inserted into the external device.

14. A system, comprising:
an audio device (200); and
a universal serial bus (USB) cradle (100), comprising:
a USB connector (104) configured to engage the USB cradle with an external device (306); and
a cradle base (102) integrated with the USB connector, the cradle base including:
a cavity (108) configured to accept the audio device in a docked configuration; and
a magnetic connector (106) configured to hold the audio device in a given position and orientation when the audio device is docked with the USB cradle.

15. The system of Claim 14, further comprising a control circuit (402) configured to either:
determine (625) at a first time that the audio device is not docked with the USB cradle;
based upon a determination that the audio device is not docked with the USB cradle, cause (655) a wireless data link to be provided between the audio device and the external device;
determine (665) at a second time after the first time that the audio device is docked with the USB cradle and that (610) the USB cradle is inserted into the external device;
based upon the determination that the audio device is docked with the USB cradle and that the USB cradle is inserted into the external device at the second time, cause (670) the wireless data link to be switched to a wired data link between the audio device and the external device;
or
determine (625) at a first time that the audio device is docked with the USB cradle and that (610) the USB cradle is inserted into the external device;
based upon a determination that the audio device is docked with the USB cradle, provide (630) a wired data link between the audio device and external device;
determine (640) at a second time after the first time that the audio device is not docked with the USB cradle;
based upon the determination that the audio device is not docked with the USB cradle at the second time, cause (670) the wired data link to be switched to a wireless data link between the audio device and the external device.
